# EUROPEAN PATENT APPLICATION

(11) **EP 4 686 347 A1**
(43) Date of publication of application: **28.01.2026**
(21) Application number: 25160809.7
(22) Date of filing: 28.02.2025
(51) Int. Cl.: H10F 19/90, H10F 77/20

(54) **SOLAR CELL STRUCTURE AND PHOTOVOLTAIC MODULE**

(30) Priority: 26.07.2024 CN 202411023179
(71) Applicant: TONGWEI SOLAR (HEFEI) CO., LTD., Hefei, Anhui 230088 (CN)
(72) Inventor: Ding, Changlin, Anhui, 230088 (CN); Xia, Zhengyue, Anhui, 230088 (CN); Xing, Guoqiang, Anhui, 230088 (CN)
(74) Representative: Michalski Hüttermann & Partner Patentanwälte mbB

(57) **Abstract**

A solar cell structure includes: a solar cell; an adhesive portion including a plurality of fixing adhesive points provided on a surface of the solar cell at intervals in a first direction; and a conductive component, a surface of the conductive component facing the solar cell being provided with a plurality of first contact regions and a plurality of second contact regions arranged alternately in the first direction; the conductive component is fixed to the plurality of fixing adhesive points through the plurality of first contact regions, the plurality of fixing adhesive points electrically isolate the solar cell from the conductive component in the plurality of first contact regions, the conductive component is electrically in contact with a region on the solar cell other than the plurality of fixing adhesive points through the plurality of second contact regions, to form discontinuous contact between the conductive component and the solar cell.

## Description

### TECHNICAL FIELD

The present application relates to the field of photovoltaic technology, particularly to a solar cell structure and a photovoltaic module.

### BACKGROUND

At present, the interconnection of photovoltaic modules is mainly implemented through a soldering pad made of a metallized paste in a partial region of a busbar of a solar cell. A PV ribbon is soldered to the pad through an instantaneous soldering process to form a stable and reliable electrical combination, that is, a series soldering part of the photovoltaic module manufacturing. A large quantity of metallized paste needs to be consumed in the soldering pad and the conventional solar cell busbar, and a large quantity of busbar pastes is required to ensure the soldering quality and provide enough tension between the PV ribbon and the solar cell. In addition, the soldering pad may also cause a certain degree of shading on a front surface of the solar cell, thereby greatly reducing a light-receiving area of the solar cell. Accordingly, a photoelectric conversion efficiency of the solar cell is limited, and it is difficult to further reduce the cost.

In view of this, the industry proposes a novel 0-Busbar (0BB) solar cell and a novel 0BB assembly. There is no conventional busbar and soldering pad on the front and back of the solar cell. Compared to the conventional solar cell, the photoelectric conversion efficiency and the quantity of the metallized pastes of the 0BB solar cell are significantly optimized. At present, the 0BB interconnection and assembly formed based on the 0BB solar cells include the following technical solutions. Solution 1: after the solar cells are loaded, a photocurable adhesive is printed, the PV ribbons are arranged and solidified by using the ultraviolet ray, and then the laminate soldering is performed. Solution 2: a thermal-curing adhesive is printed after the solar cells are loaded, the PV ribbons are arranged and solidified by heating, and then the laminate soldering is performed. Solution 3: the solar cells are loaded before the PV ribbons are arranged, PV ribbon protective films are arranged and heated to fix the PV ribbons, and then the laminate soldering is performed. Solution 4: the solar cells are loaded before the PV ribbons are arranged, the PV ribbons are fixed by using the instantaneous high temperature soldering and solidified by applying the photocurable adhesive combined with ultraviolet, and then the laminate soldering is performed.

However, in the solution 1, the solution 2, and the solution 3, the PV ribbon protective films are required, so that the cost is high. In a practical process of the photovoltaic module, a hot spot effect inevitably occurs. A hot spot temperature is generally higher than a soldering melting point of the PV ribbon, which may lead to secondary melting of the PV ribbon during the hot spot, and further lead to weakening of the electrical connection. In the solution 4, a moderately high temperature PV ribbon is used without using the PV ribbon protective film, the cost is relatively acceptable. However, the stringing process of the solar cells is complex, which may lead to an undesirable electrical connection of the solar cell string, accordingly it is difficult to control the process.

### SUMMARY

In view of this, in order to address the above technical problems of high cost, hot spot problem, and complexity of manufacturing process when the photovoltaic module is manufactured, a solar cell structure and a photovoltaic module are provided, which can ensure a light-receiving area of the solar cell, and avoid a hot spot effect of the photovoltaic module in the practical process. In addition, there is no need to use a PV ribbon protective film, the manufacturing cost is reduced, and the manufacturing process is simplified.

A solar cell structure is provided, including: a solar cell; an adhesive portion including a plurality of fixing adhesive points which are provided on a surface of the solar cell at intervals in a first direction; and a conductive component, a surface of the conductive component facing the solar cell being provided with a plurality of first contact regions and a plurality of second contact regions, the plurality of first contact regions and the plurality of second contact regions being arranged alternately in the first direction. The conductive component is fixed to the plurality of fixing adhesive points through the plurality of first contact regions, the plurality of fixing adhesive points electrically isolate the solar cell from the conductive component in the plurality of first contact regions, the conductive component is electrically in contact with a region on the solar cell other than the plurality of fixing adhesive points through the plurality of second contact regions, to form a discontinuous contact between the conductive component and the solar cell.

In an embodiment, the solar cell is provided with a plurality of gridlines, the plurality of gridlines are provided on the surface of the solar cell at intervals in the first direction, the plurality of gridlines extend in a second direction perpendicular to the first direction, and a connection region on the solar cell is formed between every two adjacent gridlines; the plurality of fixing adhesive points are provided in a plurality of connection regions and/or on the plurality of gridlines, and the conductive component is electrically, through the plurality of second contact regions, in contact with the plurality of gridlines and the plurality of connection regions on the solar cell other than the plurality of fixing adhesive points.

In an embodiment, each connection region is provided with a fixing adhesive point; or a part of the connection regions are provided with the fixing adhesive points, at least a part of the fixing adhesive points are arranged adjacent to each other, and/or at least a part of the fixing adhesive points are spaced from each other by at least one connection region.

In an embodiment, each gridline is provided with a fixing adhesive point; or a part of the gridlines are provided with the fixing adhesive points, at least a part of the fixing adhesive points are arranged adjacent to each other, and/or at least a part of the fixing adhesive points are spaced from each other by at least one gridline.

In an embodiment, there exists a plurality of adhesive portions which are provided on the surface of the solar cell at intervals in a second direction perpendicular to the first direction, and each adhesive portion is connected to a conductive component.

In an embodiment, a fixing adhesive point at least partially covers the conductive component in a circumferential direction of the conductive component; and/or the conductive component includes an electric conductor and a metal solder, the metal solder coats an outer side of the electric conductor, and the metal solder is electrically in contact with the solar cell in a second contact region.

In an embodiment, a shape of a fixing adhesive point is a hemispherical shape, a square shape, a shape formed by splicing straight lines, a shape formed by splicing curves, or a shape formed by splicing straight lines and curves; the plurality of fixing adhesive points has the same shape and/or different shapes.

In an embodiment, a ratio of a sum of lengths of the first contact regions in the first direction to a length of the solar cell is less than or equal to 50%; and/or a ratio of the sum of lengths of the first contact regions in the first direction to the length of the solar cell is greater than or equal to 1%.

In an embodiment, a distance between any two adjacent first contact regions in the first direction is the same and/or different; and/or sizes of the plurality of first contact regions in the first direction are the same and/or different.

A photovoltaic module is provided, including a solar cell string, a cover plate, and a backplane, wherein the cover plate and the backplane are provided on both sides of the solar cell string, the cover plate, the backplane, and the solar cell string are encapsulated through an encapsulation process. The solar cell string includes a plurality of solar cell structures according to any one of the above embodiments, and the plurality of solar cell structures are connected to each other in series to form the solar cell string.

With the aforementioned technical solution, the present invention has at least the following technical effects.

According to the battery structure and the photovoltaic component of this application, the fixing adhesive points can electrically isolate the solar cell from the conductive component in the first contact regions, and the plurality of second contact regions of the conductive component can be electrically in contact with a region on the solar cell other than the fixing adhesive points. In such a manner, the conductive component is electrically isolated from the solar cell through the fixing adhesive points, and the conductive component is electrically in contact with the solar cell in other regions, so that the discontinuous contact can be formed between the solar cell and the conductive component.

In such a manner, the plurality of fixing adhesive points provided at intervals can implement the reliable fixation between the conductive component and the solar cell, and avoid a decrease in the light-receiving area of the solar cell, thereby avoiding a hot spot effect in a practical process of the photovoltaic module as much as possible, and ensuring the reliability of electrical contact between the conductive component and the solar cell. When the photovoltaic module is manufactured with the solar cell structure in the present invention, the conductive component can be fixed onto the solar cell through low-temperature long-time soldering without using the PV ribbon protective film, and accordingly, the manufacturing cost is reduced. In addition, there is no need to flip the solar cells in the manufacturing process of the solar cell string, thereby ensuring the stability of the process, simplifying the manufacturing process of the photovoltaic module, and guaranteeing the reliability of the photovoltaic module.

### BRIEF DESCRIPTION OF THE DRAWINGS

FIG. 1 is a schematic diagram of a solar cell structure according to an embodiment of the present invention.
FIG. 2 is a partial perspective view of the solar cell structure shown in FIG. 1.
FIG. 3 is a cross-sectional view of the solar cell structure shown in FIG. 2 in a first direction according to an embodiment of the present invention.
FIG. 4 is a cross-sectional view of the solar cell structure shown in FIG. 2 in a first direction according to another embodiment of the present invention.
FIG. 5 is a cross-sectional view of the solar cell structure shown in FIG. 2 in a first direction according to another embodiment of the present invention.
FIG. 6 is a cross-sectional view of the solar cell structure shown in FIG. 3 at A-A.
FIG. 7 is a cross-sectional view of the solar cell structure shown in FIG. 3 at B-B.
FIG. 8 is a cross-sectional view of the solar cell structure shown in FIG. 5 at C-C.
FIG. 9 is a cross-sectional view of the solar cell structure shown in FIG. 4 at D-D.
FIG. 10 is a side view of the solar cell structure shown in FIG. 2.

Reference signs:
100, solar cell structure; 110, solar cell; 111, gridline; 112, connection region; 120, adhesive portion; 121, fixing adhesive point; 130, conductive component; 131, first contact region; 132, second contact region; 133, electric conductor; 134, metal solder.

### DETAILED DESCRIPTION OF THE EMBODIMENTS

In order to make the purpose, technical solution and advantages of the present invention more clearly understood, the present invention is further described in detail below in conjunction with the accompanying drawings and embodiments. Many specific details are described below to facilitate full understanding of the present invention. However, the present invention may be implemented in many different manners from those described herein. A person skilled in the art can make similar improvements without departing from the conception of the present invention. Accordingly, the present invention is not limited to the specific embodiments disclosed below.

In the description of the present invention, it should be appreciated that, when terms such as "center", "longitudinal", "horizontal", "length", "width", "thickness", "upper", "lower", "front", "back", "left", "right", "vertical", "horizontal", "top", "bottom", "inside", "outside", "clockwise", "anticlockwise", "axial", "radial", and "circumferential", and the like appear, the orientations or positional relationships indicated by these terms are based on the accompanying drawings, and these terms are merely intended to facilitate the description and simplification, rather than indicating or implying that the a device or element definitely has a specific orientation, or is constructed and operates according to the specific orientation, and thus these terms are not understood as restrictions on the present invention.

In addition, when terms such as "first" or "second" and the like appear, these terms are merely used for the purpose of description, and are not understood as indicating or implying relative importance or implicitly indicating the number of the specific technical features. Accordingly, a feature defined with "first" or "second" may explicitly or implicitly include at least one of the features. In the description of the present invention, when there exists a term "multiple", the meaning of which is at least two, for example, two, three, unless otherwise specifically limited.

In the present invention, unless otherwise specified and limited, when terms "installation", "coupling", "connection", "fixing" and the like appear, these terms shall be understood broadly. For example, the connection may be a fixed connection, or a detachable connection, or may be integrated into one; the connection may be a mechanical connection, or an electrical connection; the connection may be a direct connection, or an indirect connection through an intermediate medium, or an internal communication of two components, or an interaction relationship between two components, unless otherwise specifically limited. A person of ordinary skill in the art may understand specific meanings of the above terms in the present invention according to specific conditions.

In the present invention, unless otherwise specified and limited, when a first feature is described as being "on" or "under" a second feature, it may mean that the first feature is directly in contact with the second feature, or the first feature is indirectly in contact with the second feature through an intermediate medium. In addition, the first feature is "on", "above", "upper" the second feature may be that the first feature is directly or diagonally above the second feature, or only indicates that the level of the first feature is higher than the level of the second feature. The first feature is "below", "lower", "beneath" the second feature may be that the first feature is directly or diagonally below the second feature, or merely indicates that the level of the first feature is lower than the level of the second feature.

It should be noted that when a component is referred to as being "fixed" or "provided" on another component, the component may be directly on another component or there may exist an intermediate component. When a component is regarded as being "connected" to another component, the component may be connected directly to another component, or there may exist an intermediate component. The terms "vertical", "horizontal", "upper", "lower", "left", "right", and the like used in the present invention are merely for description, and are not intended to represent the only implementation mode.

It should be appreciated that at present, the interconnection of the photovoltaic modules is implemented mainly through a soldering pad made of a metallized paste in a partial region of a busbar of a solar cell. A PV ribbon is soldered to the soldering pad through an instantaneous soldering process to form a stable and reliable electrical combination. However, the soldering pad may reduce a light-receiving area of the solar cell, affect the photoelectric conversion efficiency, and further increase the cost. In view of this, a 0BB solar cell is proposed, which can ensure the photoelectric conversion efficiency of the solar cell and reduce a quantity of metallized paste. However, at present, a PV ribbon protective film needs to be used during manufacturing of the 0BB solar cell, and a hot spot problem may occur, so that the electrical connection is weakened, and the stringing process of the solar cells is complex and is difficult to control.

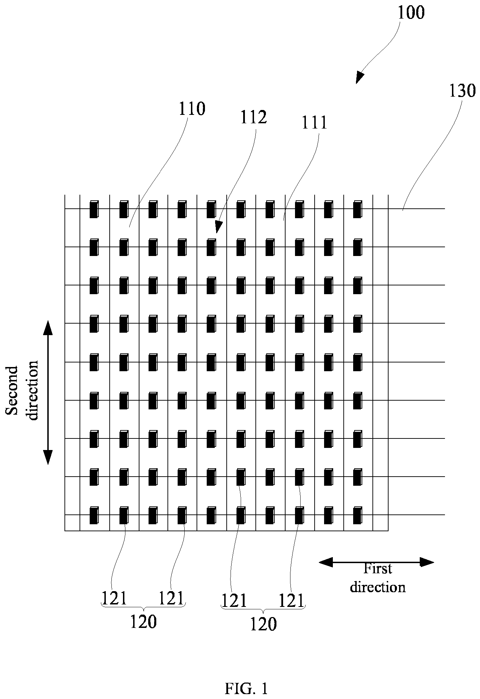

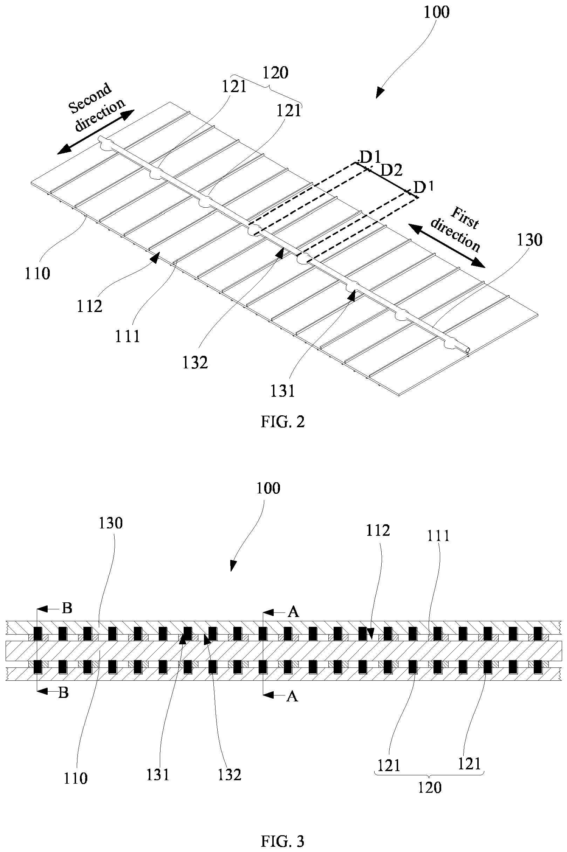

Referring to FIG. 1 and FIG. 2, the present invention provides a novel solar cell structure 100. FIG. 1 is a schematic diagram of a solar cell structure 100 according to an embodiment of the present invention, and FIG. 2 is a partial perspective view of the solar cell structure 100 shown in FIG. 1. A solar cell string (not shown) can be manufactured by connecting the solar cell structures 100 , and a photovoltaic module (not shown) can be formed after the solar cell string is encapsulated through an encapsulation process. The solar cell structure 100 in the present invention can ensure a light-receiving area of the solar cell 110, and avoid a hot spot effect of the photovoltaic module in use. In addition, no PV ribbon protective film is required, the manufacturing cost is reduced, and a manufacturing process is simplified. A specific structure of the solar cell structure 100 in an embodiment is described as follows.

Referring to FIG. 1 and FIG. 2, in an embodiment, the solar cell structure 100 may include a solar cell 110, an adhesive portion 120, and a conductive component 130. The adhesive portion 120 may include a plurality of fixing adhesive points 121 which are provided on a surface of the solar cell 110 at intervals in a first direction. A surface of the conductive component 130 facing the solar cell 110 is provided with a plurality of first contact regions 131 and a plurality of second contact regions 132. The plurality of first contact regions 131 and the plurality of second contact regions 132 are arranged alternately in the first direction. The conductive component 130 is fixed to the fixing adhesive points 121 through the first contact regions 131. The fixing adhesive points 121 can electrically isolate the solar cell 110 from the conductive component 130 in the first contact regions 131. The conductive component 130 is electrically in contact with a region on the solar cell 110 other than the fixing adhesive point 121 through the second contact regions 132, so that a discontinuous contact is formed between the conductive component 130 and the solar cell 110.

The solar cell 110 is made of a silicon wafer. The solar cell 110 is configured to absorb solar energy, and convert the solar energy into electric energy. The specific structure and principle of the solar cell 110 are well known, and the details are not described herein again. The solar cell 110 extends in a first direction and a second direction as shown in FIG. 1 and FIG. 2. The first direction is perpendicular to the second direction. The first direction is a length direction of the solar cell 110, and the second direction is a width direction of the solar cell 110. The solar cell 110 has a specific length in the first direction and a specific width in the second direction.

The adhesive portion 120 is provided on a surface of the solar cell 110 in the first direction. The conductive component 130 is provided on the adhesive portion 120, and is electrically in contact with the solar cell 110. It should be appreciated that the solar cell 110 has a front surface and a back surface opposite each other. As shown in FIG. 2 and FIG. 3, FIG. 3 is a cross-sectional view of the solar cell 100 shown in FIG. 2 in the first direction. In FIG. 3, an upper surface of the solar cell 110 is the front surface, and a lower surface of the solar cell 110 is the back surface. Both the front surface and the back surface of the solar cell 110 are provided with the adhesive portion 120, and each adhesive portion 120 is fixed with a conductive component 130. In addition, the up and down directions in the present invention are based on the directions shown in FIG. 2 and FIG. 3.

In other words, both the upper surface (the front surface) and the lower surface (the back surface) of the solar cell 110 are provided with the conductive component 130, and the conductive component 130 is fixed to the surface of the solar cell 110 through the corresponding adhesive portion 120. It should be noted that a principle of the upper surface of the solar cell 110 being provided with the adhesive portion 120 and the conductive component 130 is substantially the same as a principle of the lower surface of the solar cell 110 being provided with the adhesive portion 120 and the conductive component 130. In the following description, only the upper surface of the solar cell 110 provided with the adhesive portion 120 and the conductive component 130 is taken as an example for illustration.

The adhesive portion 120 is provided on a surface of the solar cell 110. The conductive component 130 is provided on the adhesive portion 120, and is electrically in contact with a region on the solar cell 110 other than the adhesive portion 120. The adhesive portion 120 can reliably fix the conductive component 130 onto the solar cell 110 without providing a soldering pad, that is, the adhesive portion 120 can provide enough tension between the conductive component 130 and the solar cell 110, thereby ensuring reliability of connection between the conductive component 130 and the solar cell 110, reducing the cost, and further reducing light shielding to ensure the photoelectric conversion efficiency.

In addition, the conductive component 130 is further capable of being electrically in contact with a region on the solar cell other than the adhesive portion 120, to collect a current generated by the solar cell 110. Specifically, the adhesive portion 120 includes a plurality of fixing adhesive points 121 which are provided at intervals in the first direction, that is, there exists a distance between two adjacent fixing adhesive points 121 in the first direction. A lower surface of the conductive component 130 is provided with a plurality of first contact regions 131 and a plurality of second contact regions 132. The plurality of first contact regions 131 correspond to the fixing adhesive points 121 in a one-to-one correspondence. The plurality of first contact regions 131 and the plurality of second contact regions 132 are arranged alternately in the first direction.

When the conductive component 130 is connected to the adhesive portion 120 and the solar cell 110, the conductive component 130 is fixed onto the adhesive portion 120 through the first contact regions 131, and the conductive component 130 is connected to the solar cell 110 through the second contact regions 132. It should be appreciated that, when the solar cell structure 100 is manufactured, the adhesive portion 120 is provided on the solar cell 110 in advance, and then the first contact regions 131 of the conductive component 130 are provided on the fixing adhesive points 121. In such a manner, the fixing adhesive points 121 can keep the first contact regions 131 out of contact with the solar cell 110 in positions of the first contact regions, that is, the conductive component 130 is electrically isolated from the solar cell 110 in the positions of the first contact regions 131, and the conductive component 130 is electrically in contact with a region on the solar cell 110 other than the fixing adhesive points 121 in positions of the second contact regions 132.

In other words, the fixing adhesive points 121 can electrically isolate the conductive component 130 from the solar cell 110 in the first contact regions 131, so that the first contact regions 131 of the conductive component 130 are insulated from the solar cell 110, and the second contact regions 132 of the conductive component 130 are electrically in contact with a region on the solar cell 110 without the fixing adhesive point 121. That is, the conductive component 130 is electrically isolated from the solar cell 110 through the fixing adhesive points 121 in a partial region on the solar cell 110, while the conductive component 130 is in normal electrical contact with the solar cell 110 in other regions on the solar cell 110. In such a manner, compared to the existing manner in which the conductive component 130 is fully in contact with the solar cell 110, in the present invention, a plurality of fixing adhesive points 121 provided at intervals in the first direction can form a discontinuous contact between the solar cell 110 and the conductive component 130.

For the solar cell structure 100 described in the above embodiment, a plurality of fixing adhesive points 121 provided at intervals can form a discontinuous contact between the solar cell 110 and the conductive component 130, the reliable fixation of the conductive component 130 on the solar cell 110 is implemented, and a decrease in the light-receiving area of the solar cell 110 is avoided, thereby avoiding a hot spot effect during the use of the photovoltaic module as much as possible, and ensuring the reliability of electrical contact between the conductive component 130 and the solar cell 110. When the photovoltaic module is manufactured with the solar cell structure 100 in the present invention, the conductive component 130 can be fixed onto the solar cell through low-temperature long-time soldering without using a PV ribbon protective film, and accordingly, the manufacturing cost is reduced. In addition, there is no need to flip the solar cells in the manufacturing process of the solar cell string, thereby ensuring the stability of the process, simplifying the manufacturing process of the photovoltaic module, and guaranteeing the reliability of the photovoltaic module.

A structural form in which the plurality of fixing adhesive points 121 form a discontinuous contact between the conductive component 130 and the solar cell 110 in the present invention may also be applied to a solar cell 110 with a soldering pad. In the present invention, only the solar cell 110 without a soldering pad is taken as an example for illustration.

Referring to FIG. 1 to FIG. 3, in an embodiment, the solar cell 110 is provided with a plurality of gridlines 111. The plurality of gridlines 111 are provided on a surface of the solar cell 110 at intervals in the first direction. The gridlines 111 extend in a second direction perpendicular to the first direction, and a connection region 112 on the solar cell 110 is formed between two adjacent gridlines 111. The plurality of fixing adhesive points 121 are provided in the connection regions 112 and/or on the gridlines 111, and the conductive component 130 is electrically, through the second contact regions (132), in contact with the gridlines 111 and the connection regions 112 on the solar cell 110 other than the fixing adhesive points 121.

The solar cell 110 has a 0BB structure, a plurality of gridlines 111 are provided on an upper surface of the solar cell 110, and the gridlines 111 are configured to collect the current of the solar cell 110. The plurality of gridlines 111 extend in the second direction and are provided at intervals in the first direction. There exists a distance between adjacent gridlines 111 in the first direction, and the gridlines 111 form an intersection relationship with the conductive component 130. Further, the gridlines 111 are perpendicular to the conductive component 130. In such a manner, the conductive component 130 can be electrically in contact with the gridlines 111, to collect and transmit the current in the first direction perpendicular to the gridlines 111.

For ease of describing a position of a fixing adhesive point 121, a region between two gridlines 111 on the solar cell 110 is referred to as a connection region 112. The solar cell 110 is provided with a plurality of connection regions 112. The plurality of connection regions 112 and the plurality of gridlines 111 are arranged alternately in the first direction. There exists one connection region 112 between two adjacent gridlines 111, and one gridline 111 is provided between two adjacent connection regions 112. The plurality of fixing adhesive points 121 are provided in the connection regions 112 and/or on the gridlines 111. In such a manner, after the first contact regions 131 of the conductive component 130 are fixed to the fixing adhesive points 121, the first contact regions 131 are electrically isolated from the connection regions 112 and/or the gridlines 111 through the fixing adhesive points 121, and the conductive component 130 is, through second contact regions 132, electrically in contact with the connection regions 112 and the gridlines 111 on the solar cell 110 other than the fixing adhesive points 121.

As shown in FIG. 3, in an embodiment of the present invention, the fixing adhesive points 121 are provided in the connection regions 112 and on the gridlines 111, and the conductive component 130 is electrically in contact with the connection region 112 and the gridlines 111 on the solar cell 110 other than the fixing adhesive points 121.

In other words, the fixing adhesive points 121 in the embodiment are distributed in the connection regions 112 and on the gridlines 111. In a region with a fixing adhesive points 121, the conductive component 130 is electrically isolated from the solar cell 110 through the fixing adhesive points 121. In a region without the fixing adhesive point 121, the conductive component 130 is directly electrically in contact with the solar cell 110. Accordingly, a discontinuous contact between the conductive component 130 and the solar cell 110 is implemented.

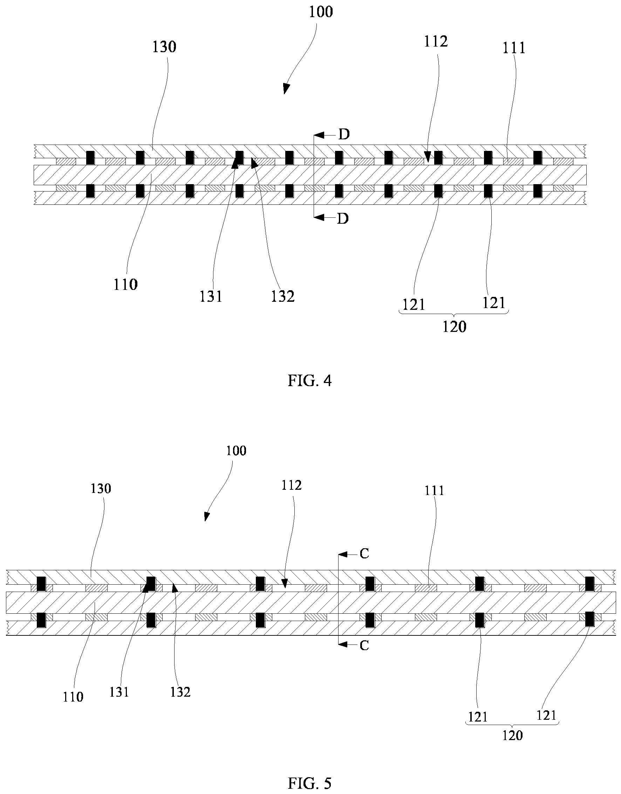

As shown in FIG. 4, FIG. 4 is a cross-sectional view of the solar cell structure 100 shown in FIG. 2 in the first direction according to another embodiment. In the embodiment of the present invention, the fixing adhesive points 121 are provided in the connection regions 112, and the conductive component 130 is electrically in contact with the connection regions 112 other than the fixing adhesive points 121 and the gridlines 111 on the solar cell 110.

In other words, the fixing adhesive points 121 in the embodiment are distributed in the connection regions 112, and no fixing adhesive point 112 is provided on the gridlines 111. The conductive component 130 is electrically in contact with all the gridlines 111, and is further electrically in contact with regions in the connection regions 112 other than the fixing adhesive points 121. In a region with a fixing adhesive point 121, the conductive component 130 is electrically isolated from the solar cell 110 through the fixing adhesive point 121, and in a region without the fixing adhesive point 121, the conductive component 130 is directly electrically in contact with the solar cell 110, to implement the discontinuous contact between the conductive component 130 and the solar cell 110.

As shown in FIG. 5, FIG. 5 is a cross-sectional view of the solar cell structure 100 shown in FIG. 2 in the first direction according to another embodiment. In the embodiment of the present invention, the fixing adhesive points 121 are disposed on the gridlines 111, and the conductive component 130 is electrically in contact with the connection regions 112 and the gridlines 111 on the solar cell 110 other than the fixing adhesive points 121.

In other words, the fixing adhesive points 121 in the embodiment are distributed on the gridlines 111, and no fixing adhesive point 121 is provided in the connection regions 112, so that the conductive component 130 is electrically in contact with all the connection regions 112, and is further electrically in contact with regions on the gridlines 111 other than the fixing adhesive points 121. In a region with a fixing adhesive point 121, the conductive component 130 is electrically isolated from the solar cell 110 through the fixing adhesive point 121, and in a region without the fixing adhesive point 121, the conductive component 130 is directly electrically in contact with the solar cell 110, to implement the discontinuous contact between the conductive component 130 and the solar cell 110.

Referring to FIG. 3 and FIG. 4, in an embodiment, a length of the fixing adhesive point 121 in the first direction is less than a length of the connection region 112 in the first direction. After the fixing adhesive point 121 is provided in the connection region 112, the fixing adhesive point 121 only partially covers the connection region 112 in the first direction, and there exists a specific distance between the fixing adhesive point 121 and a gridline 111 on at least one side of fixing adhesive point 121 in the first direction.

In such a manner, after the conductive component 130 is provided at the fixing adhesive points 121 through the first contact regions 131, the conductive component 130 can further be, through the second contact regions 132, electrically in contact with the connection regions 112 in which the fixing adhesive points 121 are located, to ensure an electrical contact area between the conductive component 130 and the solar cell 110, thereby ensuring an electrical connection effect between the conductive component 130 and the solar cell 110, and avoiding affecting a conductive performance of the solar cell 100.

Referring to FIG. 3 and FIG. 5, in an embodiment, a length of the fixing adhesive point 121 in the first direction is less than a length of the gridline 111 in the first direction. After the fixing adhesive point 121 is provided on the gridline 111, the fixing adhesive point 121 only partially covers the gridline 111 in the first direction, and there exists a certain distance between the fixing adhesive point 121 and the connection region 112 on at least one side of the fixing adhesive point 121 in the first direction.

In such a manner, after the conductive component 130 is provided at the fixing adhesive points 121 through the first contact regions 131, the conductive component 130 can further be, through the second contact regions 132, electrically in contact with the gridlines 111 on which the fixing adhesive points 121 are located, to ensure the electrical contact area between the conductive component 130 and the solar cell 110, and ensure the electrical contact effect between the conductive component 130 and the solar cell 110.

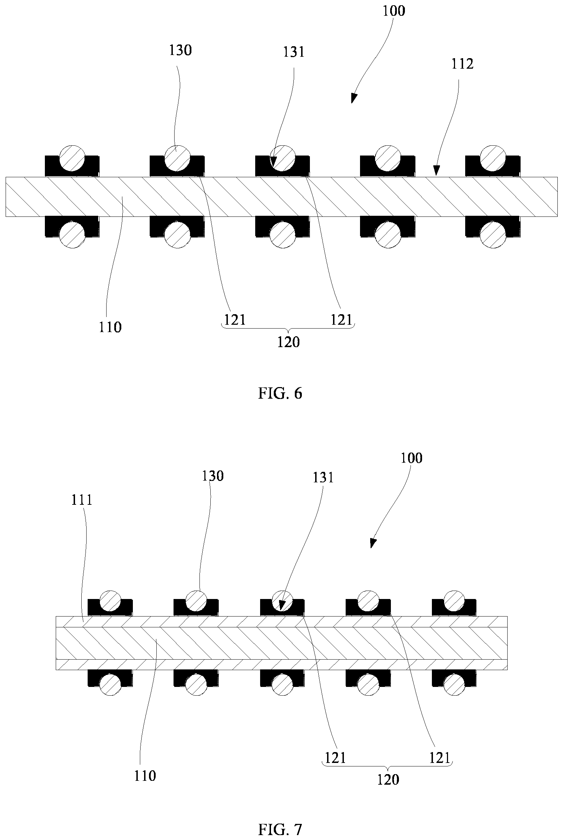

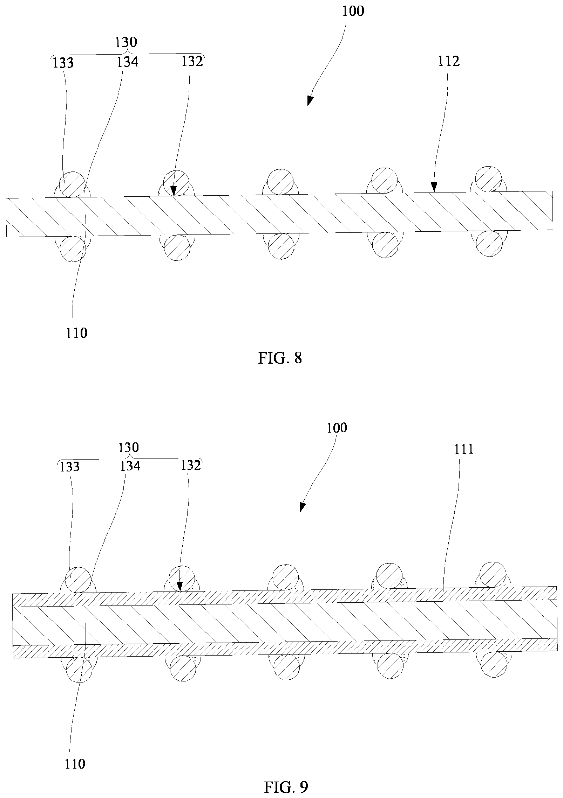

In order to better describe the connection relationship between the conductive component 130 and the solar cell 110, a cross-sectional view along the second direction is introduced herein for description. Referring to FIG. 3 and FIG. 6 to FIG. 9, FIG. 6 is a cross-sectional view of the solar cell 100 shown in FIG. 3 at A-A, FIG. 7 is a cross-sectional view of the solar cell 100 shown in FIG. 3 at B-B, FIG. 8 is a cross-sectional view of the solar cell 100 shown in FIG. 5 at C-C, and FIG. 9 is a cross-sectional view of the solar cell 100 shown in FIG. 4 at D-D. In addition, in FIG. 6 to FIG. 9, both the upper and lower surfaces of the solar cell 110 are provided with the conductive components 130.

In a first structure shown in FIG. 6, the fixing adhesive points 121 are provided in the connection region 112, and the conductive component 130 is connected to the fixing adhesive points 121 through the first contact regions 131. In FIG. 6, the lower surface of the conductive component 130 is isolated from the solar cell 110 by the fixing adhesive points 121, so that the conductive component 130 is electrically isolated from the solar cell 110 in the first contact regions 131, thereby forming the discontinuous contact between the solar cell 110 and the conductive component 130.

In a second structure shown in FIG. 7, the fixing adhesive points 121 are provided on the gridlines 111, and the conductive component 130 is connected to the fixing adhesive points 121 through the first contact regions 131. In FIG. 7, a lower surface of the conductive component 130 is isolated from the solar cell 110 through the fixing adhesive points 121, so that the conductive component 130 is electrically isolated from the solar cell 110 in the first contact regions 131, thereby forming the discontinuous contact between the solar cell 110 and the conductive component 130.

In a third structure shown in FIG. 8, the conductive component 130 is directly electrically in contact with the connection regions 112 on the solar cell 110, and the fixing adhesive points 121 may be provided in other positions in the connection regions 112, as shown in FIG. 3. The fixing adhesive points 121 may not be provided in the connection regions 112, as shown in FIG. 5. In a fourth structure shown in FIG. 9, the conductive component 130 is directly electrically in contact with the gridline 111 on the solar cell 110. The fixing adhesive points 121 may be provided in other positions on the gridline 111, as shown in FIG. 3, or the fixing adhesive points 121 may not be provided on the gridline 111, as shown in FIG. 4.

It should be noted that in the solar cell structure 100 of the present invention, the fixing adhesive points 121 may be arranged in either or both of the first structure and the second structure, and also arranged in either or both of the third structure and the fourth structure. Optionally, the connection form between the conductive component 130 and the solar cell 110 in the solar cell structure 100 may be a combination of the first structure and the second structure, or may be a combination of the first structure, the second structure, the third structure, and the fourth structure, as shown in FIG. 3.

Optionally, the connection form between the conductive component 130 and the solar cell 110 in the solar cell structure 100 may be a combination of the first structure and the fourth structure, as shown in FIG. 4. Optionally, the connection form between the conductive component 130 and the solar cell 110 in the solar cell structure 100 may be a combination of the second structure and the third structure, as shown in FIG. 5.

Certainly, in other implementation modes of the present invention, the connection form between the conductive component 130 and the solar cell 110 in the solar cell structure 100 may also be a combination of at least two of the first structure, the second structure, the third structure, and the fourth structure, as long as the discontinuous contact can be formed between the conductive component 130 and the solar cell 110.

It should be noted that the positions and the quantity of the fixing adhesive points 121 are not limited in principle, as long as the fixing adhesive points 121 can reliably fix the conductive component 130 onto the solar cell 110, and guarantee the discontinuous contact between the conductive component 130 and the solar cell 110. Several arrangement modes of the fixing adhesive points 121 are provided as follows, but not limited to the following modes.

Referring to FIG. 3 and FIG. 4, in an embodiment, each connection region 112 is provided with a fixing adhesive point 121. That is, a fixing adhesive point 121 is provided in each connection region 112 on the solar cell 110, and thus the discontinuous contact between the conductive component 130 and the solar cell 110 is implemented through the fixing adhesive points 121. Further, in the embodiment, the fixing adhesive points 121 may be provided on the gridline 111, that is, both the connection region 112 and the gridline 111 are provided with the fixing adhesive point 121. As shown in FIG. 3, the fixing adhesive points 121 may not be provided on the gridline 111, that is, the fixing adhesive points 121 are only provided in the connection regions 112, as shown in FIG. 4.

Certainly, in other implementation modes of the present invention, the fixing adhesive points 121 are provided in a part of the connection regions 112. That is, it is possible to only provide the fixing adhesive points 121 in a part of the connection regions 112, so that the discontinuous contact between the conductive component 130 and the solar cell 110 is implemented through the fixing adhesive points 121, and meanwhile, the reliability of the connection between the conductive component 130 and the solar cell 110 can be guaranteed.

When the fixing adhesive points 121 are provided in a part of the connection regions 112, the positions of the fixing adhesive points 121 are not limited in principle. Optionally, at least a part of the fixing adhesive points 121 may be arranged adjacent to each other, and/or at least a part of the fixing adhesive points 121 may be spaced from each other by at least one connection region 112. In other words, the fixing adhesive points 121 may be arranged adjacent to each other in the corresponding connection regions 112, and there is no connection region 112 without a fixing adhesive point 121 exists between adjacent fixing adhesive points 121. The fixing adhesive points 121 may be arranged at intervals in corresponding connection regions 112, and at least one connection region 112 without a fixing adhesive point 121 exists between adjacent fixing adhesive points 121. Alternatively, a part of the fixing adhesive points 121 may be provided adjacent to each other, while a part of the fixing adhesive points 121 may be provided at intervals.

Referring to FIG. 3, in an embodiment, each gridline 111 is provided with a fixing adhesive point 121. That is, a fixing adhesive point 121 is provided on each gridline 111 on the solar cell 110, and the discontinuous contact between the conductive component 130 and the solar cell 110 is implemented through the fixing adhesive points 121. Further, in the embodiment, the fixing adhesive point 121 may be provided in the connection region 112, that is, both the connection region 112 and the gridline 111 are provided with the fixing adhesive points 121. As shown in FIG. 3, the fixing adhesive point 121 may not be provided in the connection region 112, that is, the fixing adhesive point 121 is only provided on the gridline 111.

Certainly, in other implementation modes of the present invention, fixing adhesive points 121 are provided on a part of the gridlines 111, as shown in FIG. 5. In other words, the fixing adhesive points 121 are only provided on a part of the gridlines 111, the discontinuous contact between the conductive component 130 and the solar cell 110 is implemented through the fixing adhesive points 121, and meanwhile, the reliability of the connection between the conductive component 130 and the solar cell 110 can be guaranteed.

When the fixing adhesive points 121 are provided on a part of the gridlines 111, the position of the fixing adhesive points 121 are not limited in principle. Optionally, at least a part of the fixing adhesive points 121 are arranged adjacent to each other, and/or at least a part of the fixing adhesive points 121 are spaced from each other by at least one gridline 111. That is, the fixing adhesive points 121 may be arranged adjacent to each on corresponding gridlines 111, and no blank gridline 111 exists between adjacent fixing adhesive points 121. The fixing adhesive points 121 may be arranged at intervals on corresponding gridlines 111, and at least one blank gridline 111 exists between adjacent fixing adhesive points 121, as shown in FIG. 5. Alternatively, a part of the fixing adhesive points 121 may be arranged adjacent to each other, while a part of the fixing adhesive points 121 may be arranged at intervals.

Referring to FIG. 1, in an embodiment, a ratio of a sum TD1 of lengths of the first contact regions 131 in the first direction to a length L of the solar cell 110 satisfies that TD1/L≤ 50%, and/or a ratio of the sum TD1 of lengths of the first contact regions 131 in the first direction to the length L of the solar cell 110 satisfies that TD1/L≥1%.

A length of a first contact region 131 in the first direction is denoted as D1, a length of a second contact region 132 in the first direction is denoted as D2, a sum of lengths of the first contact regions 131 in the first direction is denoted as TD1, a sum of lengths of the second contact regions 132 in the first direction is denoted as TD2, and a length of the solar cell 110 in the first direction is denoted as L, where TD1/L≤50%, TD2/L≤99%, that is, 1%≤TD1/L≤50%.

In such a manner, when the length of the first contact region 131 and the length of the second contact region 132 in the first direction falls within the above-mentioned size range, the conductive component 130 can be guaranteed to be reliably fixed onto the solar cell 110 through the fixing adhesive points 121, thereby avoiding detachment of the conductive component 130 from the solar cell 110, meanwhile further guaranteeing the electrical contact performance between the conductive component 130 and the solar cell 110, so that the conductive component 130 can normally collect the current generated by the solar cell 110.

In an embodiment, a distance between any two adjacent first contact regions 131 in the first direction is the same and/or different. A distance between two adjacent first contact regions 131 is equal to a distance between two corresponding adjacent fixing adhesive points 121, and there exists a certain distance between two adjacent fixing adhesive points 121 in the first direction. Optionally, the fixing adhesive points 121 are arranged at equal intervals in the first direction. Optionally, the fixing adhesive points 121 may be arranged at unequal intervals in the first direction. Optionally, a part of the fixing adhesive points 121 are arranged at equal intervals in the first direction, while a part of the fixing adhesive points 121 are arranged at unequal intervals in the first direction.

It should be noted that a distance between two adjacent fixing adhesive points 121 is not limited in principle, as long as the conductive component 130 can be guaranteed to be reliably fixed onto the solar cell 110 through the fixing adhesive points 121, and the discontinuous contact can be guaranteed to be formed between the conductive component 130 and the solar cell 110.

In an embodiment, sizes of the first contact regions 131 in the first direction are the same and/or different. A size of the first contact region 131 in the first direction is the same as a size of the fixing adhesive point 121 in the first direction. Optionally, each fixing adhesive point 121 has the same size in the first direction. Optionally, each fixing adhesive point 121 has a different size in the first direction. Optionally, a part of the fixing adhesive points 121 have the same size in the first direction, while a part of the fixing adhesive points 121 have different sizes in the first direction.

It should be noted that the size of the fixing adhesive point 121 in the first direction is not limited in principle, as long as the fixing adhesive point 121 can guarantee the conductive component 130 to be reliably fixed onto the solar cell 110, and guarantee the discontinuous contact to be formed between the conductive component 130 and the solar cell 110.

In addition, a shape of the fixing adhesive point 121 is not limited in principle, as long as the fixing adhesive point 121 can implement the electrical isolation between the conductive component 130 and the solar cell 110. Optionally, the shape of the fixing adhesive point 121 is a hemispherical shape, a square shape, a shape formed by splicing straight lines, a shape formed by splicing curves, a shape formed by splicing straight lines and curves, or other shapes.

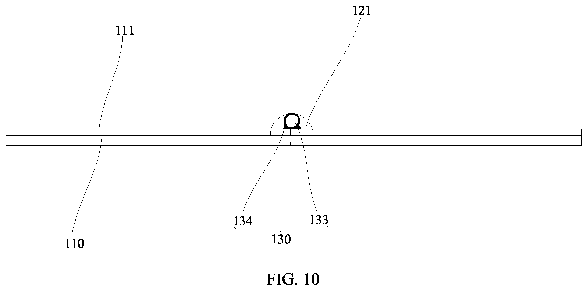

For example, as shown in FIG. 2 and FIG. 10, the fixing adhesive point 121 is of a hemispherical shape, that is, an outer outline of the fixing adhesive point 121 is semicircular. FIG. 10 is a side view of the solar cell structure 100 shown in FIG. 2. Certainly, in other implementation modes of the present invention, the fixing adhesive point 121 may be of a square or other regular or irregular shapes.

In an embodiment, the fixing adhesive points 121 have the same shape and/or different shapes. Optionally, each fixing adhesive point 121 has the same shape. Optionally, the fixing adhesive points 121 have different shapes. Optionally, a part of the fixing adhesive points 121 have the same shape, while a part of the fixing adhesive points 121 have different shapes. It should be noted that the shape of the fixing adhesive point 121 is not limited in principle, as long as the fixing adhesive point 121 can guarantee the conductive component 130 to be reliably fixed onto the solar cell 110, and guarantee the discontinuous contact to be formed between the conductive component 130 and the solar cell 110.

Referring to FIG. 1, FIG. 6, and FIG. 7, in an embodiment, there exists a plurality of adhesive portions 120 which are provided on a surface of the solar cell 110 at intervals in the second direction perpendicular to the first direction. That is, a plurality of adhesive portions 120 are arranged on the surface of the solar cell 110 at intervals in the second direction, and each adhesive portion 120 is fixed with a conductive component 130. In such a manner, a solar cell 110 can be connected to an adjacent solar cell 110 through a plurality of conductive components 130, to collect currents generated by two adjacent solar cells 110, thereby implementing the manufacturing of a solar cell string. Optionally, fixing adhesive points 121 in each adhesive portion 120 have the same and/or different arrangements.

In an embodiment, the fixing adhesive point 121 is formed of glue capable of being catalyzed to cure under a curing condition. In an embodiment, the curing condition of the fixing adhesive point 121 may be light, heat, or other types of catalytic condition. That is, the fixing adhesive point 121 may be cured through a photocuring mode, or may be cured through a thermal curing mode, or may be cured through other curing modes.

It should be noted that a type of the conductive component 130 is not limited in principle, as long as the conductive component 130 has conductivity, and a person skilled in the art may select the conductive component 130 according to requirements. For example, the conductive component 130 is a PV ribbon. Certainly, in other implementation modes of the present invention, the conductive component 130 may further be a connecting wire, a conductive strip, or the like. The conductive component 130 extends in the first direction, to electrically connect two adjacent solar cells 110.

In an embodiment, the fixing adhesive point 121 at least partially covers the conductive component 130 in a circumferential direction of the conductive component 130. That is, the fixing adhesive point 121 can cover the first contact region 131 on the conductive component 130 at least at a bottom portion of the conductive component 130, so that the first contact region 131 on the conductive component 130 is electrically isolated from the solar cell 110.

Referring to FIG. 2, FIG. 6, FIG. 7, and FIG. 10, the fixing adhesive point 121 partially covers the conductive component 130 in a circumferential direction of the conductive component 130, and the fixing adhesive point 121 covers the first contact region 131 on the conductive component 130. Certainly, in other implementation modes of the present invention, the fixing adhesive point 121 may also completely cover the conductive component 130 in the circumferential direction at a position of the first contact region 131.

Referring to FIG. 6 to FIG. 10, in an embodiment, the conductive component 130 includes an electric conductor 133 and a metal solder 134. The metal solder 134 coats an outer side of the electric conductor 133, and the metal solder 134 is electrically in contact with the solar cell 110 in the second contact region 132. In a region with a fixing adhesive point 121, the fixing adhesive point 121 electrically isolates the metal solder 134 from the solar cell 110. In a region without a fixing adhesive point 121, the metal solder 134 can be directly and electrically in contact with the solar cell 110. The metal solder 134 is configured to implement electrical connection to the connection region 112 and the gridline 111 on the solar cell 110, so that the electric conductor 133 can collect the current generated by the solar cell 110.

As shown in FIG. 6 to FIG. 10, the metal solder 134 coats an outer side of the electric conductor 133, and is accumulated on both sides. Optionally, the electric conductor 133 is generally a copper strip. Certainly, in other implementation modes of the present invention, the electric conductor 133 may be other conductive materials with better conductivity. Optionally, the metal solder 134 may include but is not limited to a multi-element solder composed of tin, lead, bismuth, silver, and the like, and a melting point of the metal solder 134 may be in a range of 140°C to 250°C. Optionally, the conductive component 130 may further include a flux-type substance that removes an oxide layer on a surface of the PV ribbon.

According to the solar cell structure 100 of the present invention, the discontinuous contact between the conductive component 130 and the solar cell 110 is implemented through a plurality of fixing adhesive points 121 arranged at intervals, so that the reliable fixation of the conductive component 130 can be implemented, and the reduction of the light-receiving area of the solar cell 110 can be avoided, thereby avoiding a hot spot effect in use of the photovoltaic module as far as possible, and guaranteeing the reliability of the electrical contact between the conductive component 130 and the solar cell 110. When a photovoltaic component is manufactured with the solar cell structure 100 in the present invention, the conductive component 130 can be fixed onto the solar cell through low-temperature long-time soldering without using the PV ribbon protective film, and accordingly the manufacturing cost is reduced. In addition, there is no need to flip the solar cells in the manufacturing process of the solar cell string, thereby ensuring the stability of the process, simplifying the manufacturing process of the photovoltaic module, and guaranteeing the reliability of the photovoltaic module.

The present invention further provides a photovoltaic module, including a solar cell string, a cover plate, and a backplane. The cover plate and the backplane are provided on both sides of the solar cell string, and the cover plate, the backplane, and the solar cell string are encapsulated through an encapsulation process. The solar cell string includes a plurality of solar cell structures 100 according to any one of the aforementioned embodiments, and the plurality of solar cell structures 100 are connected to each other in series to form a solar cell string. The solar cell structures 100 in the aforementioned embodiments form a solar cell string by electrically contacting adjacent solar cells 110 via the conductive components 130, and then the solar cell string is encapsulated through an encapsulation process, to form a photovoltaic module.

Optionally, the electrical contact may be a physical contact, or may be implemented through an alloy structure with a tensible force formed through the metal solder 134 and the solar cell 110. When the solar cell string is encapsulated to form a photovoltaic module, soldering is performed in a low-temperature long-term soldering mode. The solar cell string is placed on a heating bottom plate, and the conductive component 130 is connected to two adjacent solar cells 110. An ultra-long soldering mechanism is employed to perform low-temperature soldering on the plurality of solar cells 110 simultaneously. In this case, the ultra-long soldering mechanism cooperates with the heating bottom plate, so that the fixing adhesive points 121 on both upper and lower surfaces of the solar cell 110 can be simultaneously cured without flipping the solar cells 110, and a soldering effect is guaranteed.

When the photovoltaic module is manufactured with the solar cell structure 100 in the aforementioned embodiments, the conductive component 130 can be fixed onto the solar cell through low-temperature long-time soldering without using the PV ribbon protective film, and accordingly the manufacturing cost is reduced. In addition, the manufacturing process of the photovoltaic module is better, and there is no need to flip the solar cells in the manufacturing process of the solar cell string, thereby ensuring the stability of the process, simplifying the manufacturing process of the photovoltaic module, and guaranteeing the reliability of the photovoltaic module.

The technical features in the above embodiments may be combined arbitrarily. In order to make the description concise, all possible combinations of the technical features in the above embodiments are not described. However, as long as there is no contradiction in the combinations of these technical features, these combinations should be considered to be within the scope of the present application.

The above-described embodiments only express several implementation modes of the present invention, and the descriptions are relatively specific and detailed, but should not be construed as limiting the scope of the present invention. It should be noted that, those of ordinary skill in the art can make several transformations and improvements without departing from the concept of the present invention, and these all fall within the protection scope of the present invention. Therefore, the protection scope of the present invention should be subject to the appended claims.

## Claims

1. A solar cell structure, comprising:
a solar cell (110);
an adhesive portion (120) comprising a plurality of fixing adhesive points (121) which are provided on a surface of the solar cell (110) at intervals in a first direction; and
a conductive component (130), a surface of the conductive component (130) facing the solar cell (110) being provided with a plurality of first contact regions (131) and a plurality of second contact regions (132), the plurality of first contact regions (131) and the plurality of second contact regions (132) being arranged alternately in the first direction;
wherein the conductive component (130) is fixed to the plurality of fixing adhesive points (121) through the plurality of first contact regions (131), the plurality of fixing adhesive points (121) electrically isolate the solar cell (110) from the conductive component (130) in the plurality of first contact regions (131), the conductive component (130) is electrically in contact with a region on the solar cell (110) other than the plurality of fixing adhesive points (121) through the plurality of second contact regions (132), to form a discontinuous contact between the conductive component (130) and the solar cell (110).

2. The solar cell structure according to claim 1, wherein the solar cell (110) is provided with a plurality of gridlines (111), the plurality of gridlines (111) are provided on the surface of the solar cell (110) at intervals in the first direction, the plurality of gridlines (111) extend in a second direction perpendicular to the first direction, and a connection region (112) on the solar cell (110) is formed between every two adjacent gridlines (111);
the plurality of fixing adhesive points (121) are provided in a plurality of connection regions (112) and/or on the plurality of gridlines (111), and the conductive component (130) is electrically, through the plurality of second contact regions (132), in contact with the plurality of gridlines (111) and the plurality of connection regions (112) on the solar cell (110) other than the plurality of fixing adhesive points (121).

3. The solar cell structure according to claim 2, wherein each connection region (112) is provided with a fixing adhesive point (121); or
a part of the connection regions (112) are provided with the fixing adhesive points (121), at least a part of the fixing adhesive points (121) are arranged adjacent to each other, and/or at least a part of the fixing adhesive points (121) are spaced from each other by at least one connection region (112).

4. The solar cell structure according to claim 2, wherein each gridline (111) is provided with a fixing adhesive point (121); or
a part of the gridlines (111) are provided with the fixing adhesive points (121), at least a part of the fixing adhesive points (121) are arranged adjacent to each other, and/or at least a part of the fixing adhesive points (121) are spaced from each other by at least one gridline (111).

5. The solar cell structure according to claims 1 to 4, wherein there exists a plurality of adhesive portions (120) which are provided on the surface of the solar cell (110) at intervals in a second direction perpendicular to the first direction, and each adhesive portion (120) is connected to a conductive component (130).

6. The solar cell structure according to any one of claims 1 to 5, wherein a fixing adhesive point (121) at least partially covers the conductive component (130) in a circumferential direction of the conductive component (130); and/or
the conductive component (130) comprises an electric conductor (133) and a metal solder (134), the metal solder (134) coats an outer side of the electric conductor (133), and the metal solder (134) is electrically in contact with the solar cell (110) in a second contact region (132).

7. The solar cell structure according to any one of claims 1 to 6, wherein a shape of a fixing adhesive point (121) is a hemispherical shape, a square shape, a shape formed by splicing straight lines, a shape formed by splicing curves, or a shape formed by splicing straight lines and curves; and
the plurality of fixing adhesive points (121) has the same shape and/or different shapes.

8. The solar cell structure according to any one of claims 1 to 7, wherein a ratio of a sum of lengths of the first contact regions (131) in the first direction to a length of the solar cell (110) is less than or equal to 50%; and/or
a ratio of the sum of lengths of the first contact regions (131) in the first direction to the length of the solar cell (110) is greater than or equal to 1%.

9. The solar cell structure according to any one of claims 1 to 8, wherein a distance between any two adjacent first contact regions (131) in the first direction is the same and/or different; and/or
sizes of the plurality of first contact regions (131) in the first direction are the same and/or different.

10. A photovoltaic module, comprising a solar cell string, a cover plate, and a backplane, wherein the cover plate and the backplane are provided on both sides of the solar cell string, the cover plate, the backplane, and the solar cell string are encapsulated through an encapsulation process;
wherein the solar cell string comprises a plurality of solar cell structures (100), and the plurality of solar cell structures (100) are connected to each other in series to form the solar cell string;
wherein a solar cell structure (100) comprises:
a solar cell (110);
an adhesive portion (120) comprising a plurality of fixing adhesive points (121) which are provided on a surface of the solar cell (110) at intervals in a first direction; and
a conductive component (130), a surface of the conductive component (130) facing the solar cell (110) being provided with a plurality of first contact regions (131) and a plurality of second contact regions (132), the plurality of first contact regions (131) and the plurality of second contact regions (132) being arranged alternately in the first direction;
wherein the conductive component (130) is fixed to the plurality of fixing adhesive points (121) through the plurality of first contact regions (131), the plurality of fixing adhesive points (121) electrically isolate the solar cell (110) from the conductive component (130) in the plurality of first contact regions (131), the conductive component (130) is electrically in contact with a region on the solar cell (110) other than the plurality of fixing adhesive points (121) through the plurality of second contact regions (132), to form a discontinuous contact between the conductive component (130) and the solar cell (110).
